# EUROPÄISCHE PATENTSCHRIFT

(11) **EP 2 452 215 B1**
(45) Veröffentlichungstag und Bekanntmachung des Hinweises auf die Patenterteilung: **09.08.2017**
(21) Anmeldenummer: 10726980.5
(22) Anmeldetag: 30.06.2010
(51) Int. Cl.: C09D 183/04, G02B 5/20, G02B 5/22, C08K 13/02, C08L 83/04, H01L 31/0232

(54) **ZUSAMMENSETZUNG ZUR HERSTELLUNG EINES FILTERMATERIALS FÜR STRAHLUNG, VERFAHREN ZUR HERSTELLUNG EINER ZUSAMMENSETZUNG FÜR EIN FILTERMATERIAL, MATERIAL ZUR FILTERUNG VON STRAHLUNG UND EIN OPTOELEKTRONISCHES BAUELEMENT UMFASSEND DAS MATERIAL**
COMPOSITION FOR PRODUCING A FILTER MATERIAL FOR RADIATION, METHOD FOR PRODUCING A COMPOSITION FOR A FILTER MATERIAL, MATERIAL FOR FILTERING RADIATION, AND AN OPTOELECTRONIC COMPONENT COMPRISING THE MATERIAL
COMPOSITION POUR PRODUIRE UNE MATIÈRE FILTRANTE DESTINÉE À UN RAYONNEMENT, PROCÉDÉ POUR PRÉPARER UNE COMPOSITION POUR PRODUIRE UNE MATIÈRE FILTRANTE, MATIÈRE DESTINÉE À FILTRER UN RAYONNEMENT ET COMPOSANT OPTOÉLECTRONIQUE COMPRENANT CETTE MATIÈRE

(30) Priorität: 06.07.2009 DE 102009031915
(43) Veröffentlichungstag der Anmeldung: 16.05.2012
(73) Patentinhaber: OSRAM Opto Semiconductors GmbH, 93055 Regensburg (DE)
(72) Erfinder: HÖHN, Klaus, 91301 Forchheim (DE); SCHUMANN, Michael, 89231 Neu-Ulm (DE); SOSSENHEIMER, Dirk, 93051 Regensburg (DE)
(74) Vertreter: Epping - Hermann - Fischer
(86) Internationale Anmeldenummer: PCT/EP2010/059288
(87) Internationale Veröffentlichungsnummer: WO 2011/003788

(56) Entgegenhaltungen:
- WO-A1-2007/149624
- WO-A1-2008/035554
- GB-A- 1 201 066
- US-A1- 2008 103 267

## Beschreibung

Es wird ein optoelektronisches Bauelement mit einer Zusammensetzung nach dem Anspruch 1 angegeben.
Diese Patentanmeldung beansprucht die Priorität der deutschen Patentanmeldung 10 2009 031 915.8. Ein weit verbreitetes Problem bei der Datenübertragung, die mittels elektromagnetischer Strahlung beispielsweise von einer Sendeeinheit zu einer Empfängereinheit erfolgt, ist, dass Störungen beispielsweise durch elektromagnetische Strahlung in einem Wellenlängenbereich, der an dem zur Datenübertragung genutzten Wellenlängenbereich angrenzt, auftreten.
Die Druckschriften D1 (WO 2007/149624 A1) und D2 (US 2008/0103267 A1) beschreiben eine IR-durchlässige thermoplastische Zusammensetzung.
Die Druckschrift D3 (GB 1201066 A) beschreibt optische Elemente.
Die Druckschrift D4 (WO 2011/003788 A1) beschreibt eine Zusammensetzung zur Herstellung eines Filtermaterials für Strahlung.

Eine Aufgabe von Ausführungsformen der Erfindung besteht darin, diese Störungen zu vermindern oder gänzlich zu vermeiden.

Die Aufgabe wird durch ein optoelektronisches Bauelement mit einer Zusammensetzung nach dem Anspruch 1 gelöst. Weitere Ausführungsformen des optoelektronischen Bauelements, sowie ein Verfahren zur Herstellung einer Zusammensetzung für ein Filtermaterial in einem optoelektronischen Bauelement sind Gegenstand weiterer Patentansprüche.

Eine Ausführungsform der Erfindung betrifft ein optoelektronisches Bauelement, das elektromagnetische Strahlung einer Wellenlänge aus dem Wellenlängenbereich von 850 nm bis 1025 nm emittiert oder absorbiert,
wobei auf dem Bauelement im Strahlengang direkt eine Schicht oder ein Bauteil angeordnet ist, welches ein Material zur Filterung von Strahlung aufweist, wobei das Material durch Härtung einer Zusammensetzung erhältlich ist, wobei die Zusammensetzung umfasst:
- Silikon, und
- zumindest einen Farbstoff, der im Silikon dispergiert ist, wobei die Zusammensetzung für Strahlung der Wellenlänge zwischen 400 nm und 700 nm eine relative Transmission von kleiner 20% aufweist, und
für Strahlung der Wellenlänge zwischen 850 nm und 1025 nm eine relative Transmission von über 50% aufweist, wobei das Silikon in einem Bereich von 60 °C bis 180 °C thermisch aushärtbar ist.

Die relative Transmission bezieht sich hierbei auf den maximalen Transmissionswert (100%), welcher im Wellenlängenbereich von 700 nm bis 1100 nm erreicht wird.

Die Verwendung von Silikon als Matrixmaterial für den Farbstoff erweist sich als vorteilhaft gegenüber anderen Materialien. So weist Silikon beispielsweise gegenüber Epoxidharzen einige technische Vorteile auf. So lassen sich beispielsweise Silikone mit einer hohen Transparenz für Strahlung aus dem Infrarot-Spektrum, 780 - 1400 nm, also den Wellenlängenbereich, in dem die Datenübertragung erfolgt, herstellen. Des Weiteren weisen Silikone verglichen mit Epoxiden eine höhere optische Stabilität insbesondere gegenüber UV-Licht auf. Hierdurch weisen die Silikone eine deutlich geringere Alterungstendenz gegenüber Epoxidharzen auf. Der Einsatz von weichen Silikonen reduziert beispielsweise den thermomechanischen Stress auf das Bauelement auf dem das Silikon aufgetragen wird, wodurch die Degeneration und Alterung des Bauelements reduziert wird. Ein weiterer Vorteil von Silikonen ist, dass sie einen breiten Dauer-Temperatur-Einsatzbereich abdecken. Dieser liegt für Standardsilikone etwa im Bereich von -40 bis +150 °C, kann aber durch den Einsatz von Spezialsilikon auf beispielsweise -70 bis +200 °C erweitert werden. Diese Spezialsilikone können beispielsweise durch Destillation aufgereinigt werden, wodurch der Anteil an flüchtigen Silikonen auf beispielsweise unter 2 gew-%. Der Temperatureinsatzbereich kann aber beispielsweise auch durch den Zusatz von Stabilisatoren oder durch fluorieren der Seitengruppen erhöht werden.

Im Gegensatz zu Epoxidgießharzen sind Silikone bei der Verarbeitung beziehungsweise Aushärtung weniger feuchtesensitiv. Dies ermöglicht beispielsweise eine einfachere Verarbeitung des Silikons. Silikone weisen gegenüber Epoxiden ein günstigeres, geringeres Feuchtigkeitsaufnahmeverhalten auf.

Durch geeignete Wahl des Farbstoffs ist es möglich den Wellenlängenbereich von 400 nm bis 700 nm zu einem großen Teil herauszufiltern. Wohingegen die Zusammensetzung für einen Wellenlängenbereich zwischen 850 nm und 1025 nm eine Transmission von über 50% aufweist. Die Angaben zur relativen Transmission beziehen sich hierbei auf den maximalen Transmissionswert (100%), welche die Zusammensetzung in einen Wellenlängenbereich von 700 nm bis 1100 nm aufweist. Somit können beispielsweise Detektoren, welche elektromagnetische Strahlung aus dem Wellenlängenbereich zwischen 850 nm und 1025 nm detektieren sollen, durch beispielsweise eine Beschichtung des Strahlungseintrittsfensters mit der Zusammensetzung vor störender Strahlung, wie beispielsweise dem Tageslicht, geschützt werden.

Der Farbstoff liegt hierbei dispergiert im Silikon vor. Er muss also nicht im Silikon gelöst sein, vorzugsweise liegt er ungelöst im Silikon vor. Er kann beispielsweise als Farbstoffpartikel im Silikon vorliegen. Dadurch weist der Farbstoff eine Diffusorwirkung in der Zusammensetzung auf. Dadurch, dass der Farbstoff im Silikon ungelöst vorliegt, weisen sehr dünne Schichten (< 0,1 µm) der Zusammensetzung nur eine geringe Filterwirkung auf.

In einer weiteren Ausführungsform ist der Farbstoff homogen im Silikon verteilt.

Die homogene, gleichmäßige Verteilung des Farbstoffs im Silikon sorgt zum einen für einen gleichmäßigen optischen Eindruck der Zusammensetzung, ist aber gleichzeitig auch eine Voraussetzung dafür, dass eine Schicht, welche aus der Zusammensetzung ausgeformt wird, über ihre gesamte Fläche eine einheitliche Absorptionscharakteristik aufweist. Die homogene Verteilung ist somit auch eine Voraussetzung für die Reproduzierbarkeit bei der Herstellung einer solchen Schicht aus der Zusammensetzung.

Eine homogene Partikelverteilung bedeutet jedoch nicht, dass die Zusammensetzung zwingend agglomerat- und aggregat-frei sein muss. Homogen im Zusammenhang mit dieser Erfindung bedeutet, dass die Farbstoffpartikel Einzelpartikel und Agglomerate sein können, oder Mischungen aus beiden. Diese sind in einem ausreichend großen Volumenelement so gleichmäßig verteilt, dass vom Betrachter eine visuelle und mikroskopische Farbhomogenität wahrgenommen wird. Durch Auf- oder Durchlicht dürfen keine Inhomogenitäten feststellbar sein.

Dadurch wird im Bauelement eine einwandfreie optische Funktion erreicht. Der Farbstoffpartikelanteil, sowie Größe, Form und Verteilung der Partikel haben einen direkten Einfluss auf das Nah- und Weitfeldverhalten von optoelektronischen Sendeelementen bzw. auf deren Detektorempfindlichkeit.

Die Homogenität der Partikelverteilung, sowie die Partikelgröße können mittels eines Lichtmikroskops bestimmt werden. Hierzu kann die Zusammensetzung beispielsweise auf eine Glasplatte aufgetragen werden, und mit einer weiteren Glasplatte abgedeckt werden.

Um eine entsprechend homogene Verteilung zu erreichen ist eine gewisse Abfolge von Verfahrenschritten notwendig, welche im Zusammenhang mit dem Herstellungsverfahren erläutert werden. Des Weiteren ist eine geringe Partikelgröße von Vorteil.

Es sind jedoch auch Ausführungsformen denkbar, in denen der Farbstoff teilweise gelöst vorliegt. Dies wäre beispielsweise dann der Fall, wenn der Farbstoff über siloxanhaltige Seitenketten verfügt. Durch diese kann der Farbstoff mit dem Silikon in Wechselwirkung treten, so dass es zu einer Lösung des Farbstoffs im Silikon kommt.

In einer weiteren Ausführungsform liegt der Farbstoff im Silikon dispergiert als Partikel mit einer Größe von kleiner 200 µm vor.

Als Partikel sollen in diesem Zusammenhang Einzelpartikel bzw. Einzelpartikelagglomerate aufgefasst werden. Diese sollen kleiner 200 µm sein, wobei bei sphärischen, kugelförmigen Partikeln oder unregelmäßig geformten sogenannten Flakes oder Plättchen der maximale Durchmesser und keine mittleren Größen aus Verteilungskurven gemeint sind. Bei nadelförmigen Partikeln soll es sich entsprechend um die maximale Nadellänge handeln. Da es sich hiermit nicht um mittlere Größen handelt, werden die Partikelgrößen unter dem Mikroskop ermittelt.

Vorzugsweise liegen die Partikel in einer Größe von kleiner 50 µm in der Zusammensetzung vor.
Die Verwendung von kleinen Partikeln ermöglicht eine breitere und gleichmäßigere Verteilung des Farbstoffs im Silikon. Dies führt zum einen zu einem einheitlicheren optischen Eindruck, wie auch zu einer konstanteren Absorptionscharakteristik einer Schicht welche aus der Zusammensetzung ausgeformt wurde.

In einer weiteren Ausführungsform der Erfindung werden Farbstoffe verwendet, welche Strahlung im Wellenlängenbereich von 400 nm bis 700 nm absorbieren, ohne ein Strahlung im längerwelligen, sichtbaren Bereich zu emittieren.

In einer weiteren Ausführungsform der Erfindung umfasst die Zusammensetzung mindestens einen Farbstoff ausgewählt aus: Solvent Yellow 179, Solvent Yellow 93, Solvent Yellow 114, Solvent Orange 60, Solvent Orange 107, Solvent Red 179, Solvent Red 135, Solvent Red 111, Solvent Red 195, Solvent Red 52, Solvent Violet 36, Solvent Violet 13, Solvent Blue 97, Solvent Blue 104, Solvent Green 3, Solvent Green 28.

Durch die geeignete Auswahl eines Farbstoffs beziehungsweise einer Farbstoffkombination ist es möglich, die Strahlung des gesamten Wellenlängenbereiches von 400 nm bis 700 nm herauszufiltern.

In einer weiteren Ausführungsform umfasst die Zusammensetzung mindestens einen Farbstoff aus jeweils einer der drei Gruppen I bis III umfassend:
I) Solvent Yellow 179, Solvent Yellow 93, Solvent Yellow 114, Solvent Orange 60, Solvent Orange 107, Solvent Red 179, Solvent Red 135, Solvent Red 111, Solvent Red 195, Solvent Red 52,
II) Solvent Violet 36, Solvent Violet 13, Solvent Blue 97, Solvent Blue 104,
III) Solvent Green 3, Solvent Green 28.

In der nachfolgenden Tabelle werden zu den oben angeführten Soffen die entsprechende CAS-Nummer angegeben:

| | |
|---|---|
| Solvent Yellow 179 | CAS 80748-21-6 |
| Solvent Yellow 93 | CAS 4702-90-3 |
| Solvent Yellow 114 | CAS 75216-45-4 |
| Solvent Orange 60 | CAS 61969-47-9 |
| Solvent Orange 107 | CAS 185766-20-5 |
| Solvent Red 179 | CAS 89106-94-5 |
| Solvent Red 135 | CAS 71902-17-5 |
| Solvent Red 111 | CAS 82-38-2 |
| Solvent Red 195 | CAS 164251-88-1 |
| Solvent Red 52 | CAS 81-39-0 |
| Solvent Violet 36 | CAS 61951-89-1 |
| Solvent Violet 13 | CAS 81-48-1 |
| Solvent Blue 97 | CAS 61969-44-6 |
| Solvent Blue 104 | CAS 116-75-6 |
| Solvent Green 3 | CAS 128-80-3 |
| Solvent Green 28 | CAS 71839-01-5 |

Durch die entsprechende Kombination der Farbstoffe kann eine scharfe Absorptionskante erreicht werden. Das bedeutet, dass zwischen dem Wellenlängenbereich der absorbiert, also herausgefiltert werden soll, und dem Wellenlängenbereich, für den eine hohe Transmission angestrebt wird, nur ein sehr schmaler Wellenlängenbereich liegt. In diesem schmalen Wellenlängenbereich soll das Transmissionsverhalten der Zusammensetzung gegenüber der durch die Zusammensetzung sich ausbreitenden Strahlung vorzugsweise sprunghaft, also möglichst steil, in einem Wellenlängenbereich von vorzugsweise maximal 50 nm, besonders bevorzugt maximal 20 nm, ansteigen. Die relative Transmission sollte sich in diesem Bereich vervielfachen, beispielsweise verdoppeln vorzugsweise verdreifachen.

Des Weiteren kann durch die Kombination eine gute Absorption über den gesamten Filterbereich erzielt werden. Einzelne Farbstoffe weisen oft nur eine gute Absorption für einen kleinen Wellenlängenbereich auf, wohingegen durch die Kombination von mehreren Farbstoffen für einen Bereich von beispielsweise 400 nm bis 700 nm eine sehr gute Filterwirkung erzielt werden kann. So kann die relative Transmission durch die geeignete Wahl der Farbstoffe für einen so großen Wellenlängenbereich durchgehend unter 10% gehalten werden.

In einer weiteren Ausführungsform umfasst diese mehr als drei der oben in den Gruppen I bis III gelisteten Farbstoffe.

Durch eine noch größere Anzahl von Farbstoffen kann der Wellenlängenbereich in dem die Strahlung absorbiert wird, beziehungsweise die Steilheit der Absorptionskante noch besser eingestellt, und somit besser auf ihren Verwendungszweck abgestimmt werden.

Neben den organischen Farbstoffen kann die Zusammensetzung auch noch zusätzlich anorganische Farbstoffe umfassen wie beispielsweise farbige Übergangsmetallkomplexe wie Berliner Blau, Phthalocyanine mit Cu, Zn, Co, Mg, Fe sowie metalldotierte bzw. beschichtete (Mn, Eu oder Nano-Al, -Au, -Ag, -TiN) Silikate, Aluminate, Fluoride, Oxide und Gläser.

In einer weiteren Ausführungsform sind die Farbstoffe frei von Pb und Cd.

In einer weiteren Ausführungsform handelt es sich bei den Farbstoffen um organometallische Verbindungen, wie beispielsweise Zn- oder Cu-Phthalocyanine.

In einer weiteren Ausführungsform umfasst die Zusammensetzung eine Farbstoffkonzentration, welche unter zwei Gewichtsprozent liegt.

Eine höhere Konzentration könnte die Durchlässigkeit der elektromagnetischen Strahlung im Bereich von größer 700 nm herabsetzen und damit die optische Funktion und geforderte Empfindlichkeit im Sender- bzw. Empfängerbereich beeinträchtigen. Des Weiteren könnte eine höhere Konzentration die gleichmäßige Farbstoffpartikelverteilung in der Zusammensetzung bei einer längeren Lagerzeit beeinträchtigen.

Das Silikon ist in einem Bereich von 60 °C bis 180 °C thermisch aushärtbar. Vorzugsweise ist das Silikon in einem Bereich von 100 °C bis 150 °C thermisch aushärtbar.

Die Farbstoffpartikel können beispielsweise in eine erste Silikonkomponente eingearbeitet werden, und diese dann zusammen mit einer zweiten Silikonkomponente thermisch ausgehärtet werden.

In einer weiteren Ausführungsform weist das Silikon bei Raumtemperatur eine Viskosität im Bereich von 100 mPas bis 100.000 mPas auf. Vorzugsweise weist das Silikon bei Raumtemperatur eine Viskosität aus dem Bereich von 1.000 mPas bis 40.000 mPas auf.

Silikon dieser Viskosität hat den Vorteil, dass es eine hohe Lagerstabilität aufweist, das heißt, dass die im Silikon verteilten Farbstoffpartikel auch nach längerer Lagerzeit noch die gleiche räumliche Verteilung im Silikon aufweisen, und beispielsweise deutlich weniger stark absinken und sich am Boden des Lagergefäßes sammeln, was der Fall bei einem Silikon wäre, welches eine zu niedrige Viskosität aufweist. Bei einem Silikon einer höheren Viskosität könnten sich hingegen bei der Verarbeitung, beispielsweise bei einem Spritzgussverfahren, Schwierigkeiten durch die erhöhte Zähigkeit ergeben.

Bei einer weiteren Ausführungsform umfasst die Zusammensetzung ein Dialkylsilikon und/oder ein aromatisches Silikon.

Bei dem Silikon kann es sich somit um ein Einkomponenten-Silikon, also um ein reines Silikon, wie aber auch um ein Zweikomponenten-Silikon handeln. Es sind auch Ausführungsformen denkbar, in denen das Silikon mehr als zwei Komponenten umfasst. Durch den Zusatz von aromatischen Silikonen kann beispielsweise der Brechungsindex des Silikongemisch und somit der Brechungsindex der Zusammensetzung erhöht werden.

Bei einem Zweikomponenten-Silikon können die Farbstoffpartikel beispielsweise erst in die erste Komponente eingearbeitet werden, bevor diese dann mit der zweiten vermischt wird. Die Farbstoffpartikel können aber auch in beide Komponenten eingearbeitet werden.

Durch die Verwendung von beispielsweise Silikonen, bei denen eine oder beide Alkylgruppen durch aromatische Reste substituiert wurden, bzw. bei Silikonblockpolymeren bestehend aus Dialkylsilikonblöcken und Bereichen mit Arylalkyl- bzw. Diarylhauptkettenelementen kann der Brechungsindex variiert werden. Des Weiteren kann die Lösungsmittelbeständigkeit und das Permeationsverhalten, sowie die Haftbeständigkeit verbessert werden. Es können auch die Härte und das E-Modul erhöht werden.

Die zu vernetzende Hydrid- und C-C-Doppelbindungsfunktion können sich beispielsweise an den jeweiligen Kettenenden oder in den Seitengruppen befinden.

In einer weiteren Ausführungsform weist die Zusammensetzung einen Brechungsindex im Bereich von 1,4 bis 1,48 auf.

In einer weiteren Ausführungsform weist die Zusammensetzung einen Brechungsindex von größer 1,50 auf wodurch die Koppelverluste beim Übergang der elektromagnetischen Strahlung an der Grenzfläche des Silikons zum Chip minimiert werden.

In einer Ausführungsform weist die Zusammensetzung einen Brechungsindex in dem Bereich von 1,50 bis 1,57 auf.

In einer weiteren Ausführungsform der Zusammensetzung weist die Zusammensetzung additionsvernetzende Silikone auf. Hierbei kann es sich beispielsweise um zwei Komponenten handeln wobei eine davon eine C-C-Doppelbindung aufweist und die andere ein Hydrid. Somit kann zwischen diesen beiden Komponenten eine Hydrosilylierung erfolgen. Der Vorteil hierbei ist, dass keine Additionsnebenprodukte bei der Vernetzung anfallen.

In einer weiteren Ausführungsform ist die Zusammensetzung frei von Lösungsmitteln.

Dadurch dass der Farbstoff direkt im Silikon dispergiert werden kann, kann hierbei auf den Zusatz von Lösungsmitteln verzichtet werden. Hierdurch ist es möglich, die Silikone unabhängig davon zu wählen, ob sie von einem Lösungsmittel angegriffen werden könnten, welches dazu verwendet worden wäre, den Farbstoff in Lösung zu bringen. Ebenso muss auch bei der weiteren Verwendung der Zusammensetzung wie beispielsweise beim Auftragen der Zusammensetzung auf ein transparentes Substrat, nicht auf die Verträglichkeit zwischen einem Lösungsmittel und dem Substrat geachtet werden.

Des Weiteren müssen keine Quellungs- und Schrumpfungsphänomene bei der Verarbeitung sowie Explosionsschutzmaßnehmen und gesundheitsgefährdende Mitarbeiterexpositionen durch kritische Arbeitsplatzkonzentrationen berücksichtigt werden.

In einer weiteren Ausführungsform umfasst diese kein Epoxid. Dadurch weist die Zusammensetzung nicht die Nachteile auf, welche oben im Vergleich von Silikon und Epoxid diskutiert wurden.

In einer weiteren Ausführungsform umfasst die Zusammensetzung außer Silikonen keine weiteren polymeren Komponenten. Die Zusammensetzung kann zusätzlich auch noch einen Diffusor umfassen. Das Diffusormaterial kann beispielsweise ausgewählt sein aus CaF₂, SiO₂, BaSO₄, CaCo₃, Al₂O₃, TiO₂, ZrO₂, ZnO. Der Diffusor hat in der Zusammensetzung eine Streuwirkung in Bezug auf die elektromagnetische Strahlung und kann somit die Streuung dieser in der Zusammensetzung verstärken.

Des Weiteren kann die Zusammensetzung zusätzlich auch noch ein Eindickmittel, wie beispielsweise pyrogene Kieselsäure umfassen. Über das Eindickmittel kann beispielsweise die Viskosität der Zusammensetzung eingestellt, das Sedimentations- und Agglomerisationsverhalten der absorbierenden Schicht minimiert und die gewünschte Filterwirkung im optischen Feld homogener gestaltet und durch Streuwirkungseffekte optimiert werden.

Neben der Zusammensetzung wird auch ein Material beansprucht, welches durch Härtung einer der zuvor beschriebenen Zusammensetzung erhältlich ist.

Die Zusammensetzung kann hierbei beispielsweise zu einem Bauteil oder zu einer Schicht auf beispielsweise einem transparenten Substrat ausgehärtet sein. In einer Ausführungsform liegt die Schichtdicke hierbei in einem Bereich von 1 µm bis 2 mm, vorzugsweise in einem Bereich von 10 µm bis 1 mm. Wird die Schichtdicke hierbei zu dünn gewählt, so kann noch ein hoher Anteil von der Strahlung, welche durch die Schicht herausgefiltert werden soll, durch die Schicht hindurch gelangen. Wird die Schichtdicke zu dick gewählt, so kann dies beispielsweise zur Folge haben, dass ein zu großer Anteil an der elektromagnetischen Strahlung durch die Schicht absorbiert wird, welcher nicht durch die Schicht herausgefiltert werden soll.

Die Schicht kann beispielsweise auch Musterstrukturen wie Pixelpunkte oder Streifen aufweisen. Es können auch Flächen mit unterschiedlicher Schichtdicke ausgeformt werden.

Die ausgeformte Schicht kann auch beispielsweise zum Schutz von Lichtempfindlichen Bauteilen, wie beispielsweise Chipelementen oder Array-Anordnungen dienen.

Neben der Zusammensetzung selbst wird auch ein Verfahren zur Herstellung der Zusammensetzung beansprucht.
In einer Variante zur Herstellung einer Zusammensetzung für ein Filtermaterial umfasst das Verfahren die Verfahrensschritte: Vorlegen oder Bereitstellen eines Silikons als Verfahrensschritt A), Erwärmen des Silikons als Verfahrensschritt B), Versetzten des Silikons aus B) mit einem Farbstoff, so dass ein Dispersion entsteht als Verfahrensschritt C), Vermischen der Dispersion aus C), so dass eine Mischung entsteht als Verfahrensschritt D), Erwärmen der Mischung auf eine Temperatur zwischen 60 °C und 80 °C aus D) als Verfahrensschritt E), Dispergieren der Mischung aus E), so dass ein Zusammensetzung für ein Filtermaterial entsteht als Verfahrensschritt F), wobei die Zusammensetzung für Strahlung der Wellenlänge zwischen 400 nm und 700 nm eine relative Transmission von kleiner 20% aufweist, und für Strahlung der Wellenlänge zwischen 850 nm und 1025 nm eine relative Transmission von über 50% aufweist.

Die Farbstoffe können im Verfahrensschritt A) beispielsweise als Pulver, Pigment oder Granulat vorgelegt werden. Die Ausgangsstoffe werden vorzugsweise in ein Gefäß vorgelegt, welches frei von S- und N-haltigen Oberflächenkontaminationen ist.

Das Silikon in Verfahrensschritt B) wird vorzugsweise auf eine Temperatur im Bereich von 35 °C bis 40 °C erwärmt. Dies ermöglicht im Anschluss ein leichteres Einarbeiten des Farbstoffs.

Die Dispersion in Verfahrensschritt D) kann beispielsweise mit Rührvorrichtungen, Dreiwalzwerke oder vorzugsweise mit Dissolverscheiben bei 200 bis 800 UPM bei einer Temperatur von 20 °C bis 80 °C innerhalb von 1 bis 8 Stunden oder über Nacht erfolgen. Die Mischung kann auch mit einer Dissolverscheibe bei 300 bis 600 UPM oder einem Pendraulik-Rührer vermischt werden. Dies kann beispielsweise über einen Zeitraum von einer Stunde geschehen.

Im Verfahrensschritt E) kann beispielsweise auf eine Temperatur zwischen 60 °C und 80 °C in einem Ofen erwärmt werden. Es kann beispielsweise über einen Zeitraum von zwei Stunden erwärmt werden.

Das Dispergieren in Verfahrensschritt F) kann beispielsweise über einen Zeitraum von zwei Stunden erfolgen.

Um die Farbstoffverteilung im Silikon noch zu verbessern, kann die Zusammensetzung in einem Mixer bei 1600 bis 2000 UPM gemischt werden. Hier für kann beispielsweise ein SpeedMixer^{®} verwendet werden. Es kann beispielsweise in zwei jeweils zwei Minuten langen Schritten gemischt werden. Alternativ oder zusätzlich kann auch durch eine Behandlung mit einem Dreiwalzenstuhl homogenisiert werden.

Für den Fall, dass noch größerer Farbstoffagglomerate in der Zusammensetzung vorliegen, können diese beispielsweise mittels eines Filterprozesses abgetrennt werden. Hierdurch wird die Homogenität der Filtermasse gesteigert. Hierzu kann ein Filtermedium verwendet werden, welches keine Stoffe an die Zusammensetzung abgibt, welche die Aushärtung der Filtermasse beeinträchtigen oder inhibieren würden. Beispielsweise kann ein Filter verwendet werden, der alle Farbstoffagglomerate größer als 50 µm herausfiltert.

Die maximale Größe der Partikel bzw. der Farbstoffagglomerate in der Zusammensetzung sollte 200 µm, vorzugsweise 50 µm, besonders bevorzugt 20 µm, nicht überschreiten.

Die Dispersion in Verfahrensschritt D) kann beispielsweise durch ein Rühr- oder Dispergierverfahren, vorzugsweise über Perlmühlen, Hochgeschwindigkeitsdissolver (Ultra-Turrax), Walzverfahren oder Mixer (beispielsweise SpeedMixer^{®})vermischt werden, wobei die Mixer eine Geschwindigkeit von 2000 UPM erreichen sollten.

Die Geschwindigkeit der entsprechenden Geräte ist hierbei vorzugsweise so gewählt, dass das Silikon oder die Silikone durch die eingebrachten mechanischen Scherkräfte in den Misch- bzw. Dispergierschritten möglichst wenig im molekularen Aufbau durch Kettenabbaureaktionen verändert bzw. beschädigt werden.

Das Vermischen im Verfahrensschritt D) erfolgt vorzugsweise bei einer Temperatur im Bereich zwischen 20 °C und 80 °C. Bei einem Einkomponenten-Silikonsystem, welches thermisch aushärtbar ist, übersteigt die Mischtemperatur vorzugsweise 40 °C nicht.

In einer weiteren Variante des Verfahrens wird die Zusammensetzung aus F) auf eine Oberfläche aufgebracht, so dass eine Schicht ausgebildet wird. Dies geschieht im zusätzlichen Verfahrensschritt G).

Vor dem Aufbringen kann der Zusammensetzung auch erst noch ein Härter zugesetzt werden.

Die Schicht kann laterale Muster, sowie eine örtlich selektive Filterwirkung aufweisen.

Die ausgebildete Schicht hat hierbei vorzugsweise eine Schichtdicke von 10 µm bis 2 mm, besonders bevorzugt von 100 µm bis 1 mm. Mit einer solchen Schichtdicke wird eine ausreichende Absorption erreicht, ohne dass ein zu großer Teil der elektromagnetischen Strahlung absorbiert wird, welche durch die Schicht gelangen soll.

Die Zusammensetzung auf dem Verfahrensschritt F) kann im Verfahrensschritt G) beispielsweise aus der flüssigen Phase mit einem Dispenser oder durch Jetten aufgebracht werden. Es können aber auch Techniken verwendet werden wie beispielsweise Siebdruck, Tampondruck, Spin-Coating, Stempeltechnik, Tauchen oder Walzen. Mit der Siebdruck- oder Jet-Technologie können auch spezifische geometrische Strukturen (Punkte, Linien, Flächen) hergestellt werden. Somit können beispielsweise auch nur gezielt Teilbereiche eines Substrats beschichtet werden.

Das Aushärten der aufgetragenen Schicht kann beispielsweise bei einer Temperatur von 60 °C bis 180 °C, vorzugsweise bei einer Temperatur von 100 °C bis 150 °C erfolgen. Dies kann beispielsweise in einem In-Line-Prozess erfolgen, bei dem die Schicht erst über 15 Minuten bei 150 °C gehärtet wird und anschließend in einem Nachhärtprozess in einem separaten Ofen bei 150 °C noch über eine Stunde nachgehärtet wird, oder in einer Stufe (Batch-Prozess), beispielsweise über eine Stunde bei 150 °C.

In einer weiteren Verfahrensvariante weist die Schicht über ihre gesamte Fläche die gleiche Absorptionscharakteristik auf. Dies kann durch eine gleichmäßige Verteilung des Farbstoffs im Silikon erreicht werden. Die gleichmäßige Verteilung des Farbstoffs kann durch eine der zuvor beschriebenen Mischtechniken erreicht werden.

Neben dem Material, welches durch Härtung der Zusammensetzung erhalten werden kann, wird auch ein optoelektronisches Bauelement, welches ein solches Material umfasst beansprucht.

Eine Ausführungsform der Erfindung betrifft ein optoelektronisches Bauelement, dass elektromagnetische Strahlung einer Wellenlänge aus dem Wellenlängenbereich von 850 nm bis 1025 nm emittiert oder absorbiert. Das Bauelement umfasst hierbei im Strahlengang eine Schicht oder ein Bauteil welches ein Material umfasst, welches durch Härten der Zusammensetzung erhältlich ist.

Durch die Schicht oder das Bauteil kann die elektromagnetische Strahlung der Wellenlänge zwischen 500 nm und 700 nm weitgehend herausgefiltert werden, ohne dass ein großer Teil der elektromagnetischen Strahlung der Wellenlänge, welches das optoelektronische Bauelement emittiert oder absorbiert, durch den Filter herausgefiltert wird. Somit kann beispielsweise für den Fall, dass es sich bei dem optoelektronischen Bauelement um einen Detektor handelt, die störende Strahlung aus dem Wellenlängenbereich von 400 nm bis 700 nm herausgefiltert werden, so dass durch diese Strahlung im Detektor kein ungewolltes Signal erzeugt wird.

In einer weiteren Ausführungsform des optoelektronischen Bauelements handelt es sich bei der Schicht oder dem Bauteil um ein Tageslichtfilter. Somit kann durch diesen das emittierende oder absorbierende optische Element vor störendem Tageslicht geschützt werden.

Die Partikel fungieren bei einem optoelektronischen Bauelement beispielweise auch als Streupartikel und verstärken somit beispielsweise den durch Lichtabsorption erhaltenen Schutz vor Störsignalen aus der Umgebungsstrahlung durch Reflexionseffekte, so dass das Untergrundrauschen bzw. das Signal-Rausch-Verhältnis und damit die Detektorgüte weiter verbessert wird. Entsprechend wird auf der Senderseite abhängig von der Farbstoffzugabe und der Partikelform das Nah- und Weitfeld durch Partikelstreuung optimiert.

Im Folgenden sollen Varianten der Erfindung anhand von Figuren und Ausführungsbeispielen näher erläutert werden.
Figur 1 zeigt drei Transmissionsspektren (a - c) bei denen jeweils die relative Transmission (Sᵣₑₗ) gegen die Wellenlänge (λ) aufgetragen wurde.
Figur 2 zeigt eine schematische Seitenansicht einer Ausführungsform des optoelektronischen Bauelements, welches als Fotodiode ausgebildet ist.

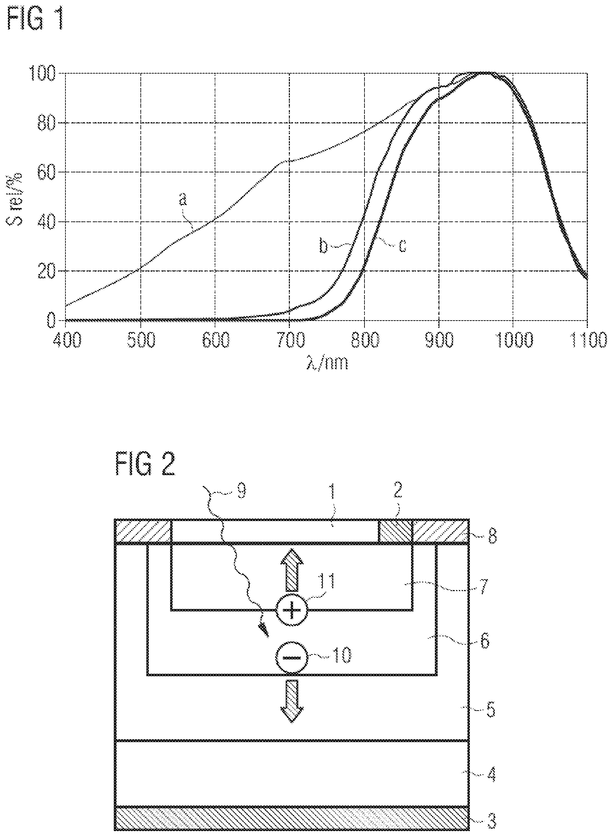

Die Figur 1 zeigt in einem Diagramm drei Transmissionsspektren a bis c, bei denen jeweils die relative Transmission (Sᵣₑₗ) in Prozent über eine Wellenlänge (λ) von 400 nm bis 1100 nm aufgetragen wurde. Die 100 Prozent stellen hierbei die höchste in diesem Wellenlängeribereich erreichte Transmission da, welche für die jeweilige Kurve erzielt wurde.

Für die Messungen wurde als Strahlungsquelle ein kalibrierter Monochromator der Firma Bentem verwendet. Als Empfänger wurde ein Chip mit einer bekannten Lichtempfindlichkeit in einem Gehäuse vergossen. Als Vergussmaterial wurde das jeweils zu vermessende Material verwendet.

Die Kurve a zeigt hierbei den Verlauf der relativen Transmission für das reine Silikon, dem kein Farbstoff zugesetzt wurde. Die Kurve a steigt in den Wellenlängenbereich von 400 nm bis etwa 950 nm stetig und näherungsweise linear, also mit gleicher Steigung, an. Nach dem Erreichen des relativen Transmissionsmaximums bei etwa 950 nm fällt die Kurve im weiteren Verlauf steil parabelförmig ab, bis sie bei einem Wellenlängenbereich von 1100 nm einen Wert für die relative Transmission von knapp 20% erreicht.

Die Kurve b zeigt den Verlauf der relativen Transmission für eine Zusammensetzung Z_{b}. Die Zusammensetzung Z_{b} umfasst hierbei ein zweikomponentiges Silikonsystem (Shin Etsu KJR 9022 E1) zu einem Anteil von 98,4 Massenprozent, einen orangen Farbstoff zu einem Anteil von 0,08 Massenprozent, einen violetten Farbstoff zu einem Anteil von 0,53 Massenprozent, einen ersten grünen Farbstoff zu einem Massenanteil von 0,20 Massenprozent, sowie einen zweiten grünen Farbstoff zu einem Anteil von 0,19 Massenprozent.

Wie in Figur 1 zu sehen ist weist die Zusammensetzung Z_{b} in den Wellenlängenbereich von 400 nm bis 700 nm so gut wie keine Transmission auf. In dem Wellenlängenbereich von 750 nm bis 900 nm steigt die Kurve b steil parabelförmig an und erreicht bei einer Wellenlänge von etwa 950 nm ihr Maximum der relativen Transmission. Nach dem Durchlaufen des Maximums fällt die Kurve ähnlich wie die Kurve a in einer parabolischen Form steil ab.

Die Kurve c zeigt die relative Transmission der Zusammensetzung Z_{c}. Die Zusammensetzung Z_{c} umfasst ein Zweikomponenten-Silikonsystem (Shin Etsu KJR 9022 E1) zu einem Anteil 98,2 Massenprozent, einen orangenen Farbstoff zu einem Anteil von 0,17 Massenprozent, einen violetten Farbstoff zu einem Anteil von 1,06 Massenprozent, einen ersten grünen Farbstoff zu einem Anteil von 0,40 Massenprozent sowie einen zweiten grünen Farbstoff zu einem Anteil von 0,37 Massenprozent.

Die Kurve c weist ebenfalls vom Wellenlängenbereich von 400 nm bis 700 nm praktisch keine relative Transmission auf. In dem Wellenlängenbereich von 750 bis 900 nm weist die Kurve c einen ähnlich steilen Anstieg auf wie die Kurve b, jedoch ist der Verlauf der Kurve c etwas zu höheren Wellenlängen verschoben. Auch die Kurve c erreicht etwa bei einer Wellenlänge von 950 nm ihr Maximum der relativen Transmission und fällt nach diesem wie auch die anderen beiden Kurven steil parabolisch ab.

Aus Figur 1 ist ersichtlich, dass durch den Zusatz einer geeigneten Farbstoffkombination in dem Wellenlängenbereich von 400 bis 700 nm eine sehr gute Filterfunktion erreicht werden kann, die bei einem reinen Silikon, wie aus Kurve a ersichtlich, nicht gegeben ist. Sowohl die Zusammensetzung Z_{b} wie auch die Zusammensetzung Z_{c} weisen eine steile Absorptionskante auf, was an dem steilen Anstieg der beiden Kurven im Bereich von etwa 750 nm bis 900 nm zu erkennen ist. Somit eignen sich die Zusammensetzungen Z_{b} und Z_{c} sehr gut als beispielsweise Tageslichtfilter. Sie können beispielsweise für optoelektronische Bauelemente verwendet werden, welche mit elektromagnetischer Strahlung aus dem Wellenlängenbereich von beispielsweise 900 bis 1000 nm arbeiten.

Die Figur 2 zeigt in einer schematischen Seitenansicht ein Ausführungsbeispiel eines optoelektronischen Bauelements, welches als Fotodiode ausgeformt ist. Diese Fotodiode umfasst einen Tageslichtfilter 1, welcher aus einem Material gefertigt ist, wie es in der Anmeldung beschrieben wurde. Der Tageslichtfilter 1 sowie der erste elektrische Kontakt 2 sind auf einer stark p-dotierten Zone 7 angeordnet. Die stark p-dotierte Zone 7 ist an ihren Seitenflächen, wie auch von der Unterseite von einer p-dotierten Zone 6 umgeben. Auf diese folgt wiederum zu den Seitenflächen wie auch zur Unterseite hin eine n-dotierte Zone 5. Die n-dotierte Zone 5 ist auf eine stark n-dotierte Zone 4 aufgesetzt die wiederum auf einem zweiten elektrischen Kontakt 3 angeordnet ist. Die Randbereiche der Oberseite sind mit einem Dielektrikum 8 versehen. Fällt nun elektromagnetische Strahlung einer Wellenlänge, welche nicht durch den Tageslichtfilter 1 gefiltert wird, auf die Oberfläche des Tageslichtfilters, so kann die elektromagnetische Strahlung, hier beispielsweise als Photon 9 dargestellt, den Tageslichtfilter 1 passieren und durch die stark p-dotierte Zone 7 zur p-dotierten Zone 6 gelangen. Hier kann es dann durch die Energie des Photons 9 zur Ladungstrennung zu einem Elektron 10 und einem Loch 11 kommen. Das Elektron 10 beziehungsweise Loch 11 können dann zum zweiten elektronischen Kontakt beziehungsweise ersten elektronischen Kontakt des Bauelements wandern. Durch die Wanderung der Ladungsträger kommt es zu einem Stromfluss im Bauelement. Der Tageslichtfilter 1 kann nun verhindern, dass durch den Einfall elektromagnetischer Strahlung aus dem Wellenlängenbereich des Tageslicht Photonen in das Innere der Fotodiode gelangen und dort durch Ladungstrennung einen ungewollten Stromfluss und somit ein nicht-gewünschtes Hintergrund-Signal in der Fotodiode auslösen.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn diese Merkmale oder diese Kombination selbst nicht explizit in den Patentansprüchen oder Ausführungsbeispielen angegeben ist.

## Patentansprüche

1. Optoelektronisches Bauelement, das elektromagnetische Strahlung einer Wellenlänge aus dem Wellenlängenbereich von 850 nm bis 1025 nm emittiert oder absorbiert,
wobei auf dem Bauelement im Strahlengang direkt eine Schicht oder ein Bauteil angeordnet ist, welches ein Material zur Filterung von Strahlung aufweist, wobei das Material durch Härtung einer Zusammensetzung erhältlich ist, wobei die Zusammensetzung umfasst:
- Silikon, und
- zumindest einen Farbstoff, der im Silikon dispergiert ist, wobei die Zusammensetzung für Strahlung der Wellenlänge zwischen 400 nm und 700 nm eine relative Transmission von kleiner 20% aufweist, und
für Strahlung der Wellenlänge zwischen 850 nm und 1025 nm eine relative Transmission von über 50% aufweist, wobei das Silikon in einem Bereich von 60 °C bis 180 °C thermisch aushärtbar ist.

2. Optoelektronisches Bauelement nach Anspruch 1,
wobei die Zusammensetzung für Strahlung der Wellenlänge zwischen 700 nm und 850 nm eine relative Transmission aufweist, welche von kleiner 20% bei 700 nm auf größer 50% bei 850 nm ansteigt.

3. Optoelektronisches Bauelement nach einem der vorhergehenden Ansprüche,
wobei der Farbstoff homogen im Silikon verteilt ist.

4. Optoelektronisches Bauelement nach einem der vorhergehenden Ansprüche,
wobei der Farbstoff als Partikel von kleiner 200 µm in der Zusammensetzung vorliegt.

5. Optoelektronisches Bauelement nach einem der vorhergehenden Ansprüche,
wobei die Zusammensetzung mindestens einen Farbstoff umfasst ausgewählt aus: Solvent Yellow 179, Solvent Yellow 93, Solvent Yellow 114, Solvent Orange 60, Solvent Orange 107, Solvent Red 179, Solvent Red 135, Solvent Red 111, Solvent Red 195, Solvent Red 52, Solvent Violet 36, Solvent Violet 13, Solvent Blue 97, Solvent Blue 104, Solvent Green 3, Solvent Green 28.

6. Optoelektronisches Bauelement nach Anspruch 5,
wobei die Zusammensetzung mindestens einen Farbstoff aus jeweils einer der drei Gruppen I bis III umfasst:
I) Solvent Yellow 179, Solvent Yellow 93, Solvent Yellow 114, Solvent Orange 60, Solvent Orange 107, Solvent Red 179, Solvent Red 135, Solvent Red 111, Solvent Red 195, Solvent Red 52,
II) Solvent Violet 36, Solvent Violet 13, Solvent Blue 97, Solvent Blue 104,
III) Solvent Green 3, Solvent Green 28.

7. Optoelektronisches Bauelement nach einem der vorhergehenden Ansprüche,
wobei die Zusammensetzung ein Dialkylsilikon und/oder aromatisches Silikon umfasst.

8. Optoelektronisches Bauelement nach einem der vorhergehenden Ansprüche,
wobei die Zusammensetzung frei von Lösungsmitteln ist.

9. Verfahren zur Herstellung einer Zusammensetzung für ein Filtermaterial in einem optoelektronischen Bauelement nach Anspruch 1 umfassen die Verfahrensschritte:
A) Bereitstellen eines Silikons,
B) Erwärmen des Silikons,
C) Versetzten des Silikons aus B) mit einem Farbstoff, so dass eine Dispersion entsteht,
D) Vermischen der Dispersion aus C), so dass eine Mischung entsteht,
E) Erwärmen der Mischung auf eine Temperatur zwischen 60 °C und 80 °C aus D),
F) Dispergieren der Mischung aus E), so dass ein Zusammensetzung für ein Filtermaterial entsteht,
wobei die Zusammensetzung für Strahlung der Wellenlänge zwischen 400 nm und 700 nm eine relative Transmission von kleiner 20% aufweist, und
für Strahlung der Wellenlänge zwischen 850 nm und 1025 nm eine relative Transmission von über 50% aufweist.

10. Verfahren nach Anspruch 9, umfassend den zusätzlichen Verfahrenschritt:
G) Aufbringen der Zusammensetzung aus F) auf eine Oberfläche, so dass eine Schicht ausgebildet wird.

11. Verfahren nach Anspruch 10,
wobei die Schicht über ihre gesamte Fläche die gleiche Absorptionscharakteristik aufweist.

12. Bauelement nach Anspruch 1,
wobei es sich bei der Schicht oder dem Bauteil um einen Tageslichtfilter handelt.

13. Optoelektronisches Bauelement nach Anspruch 1,
wobei das Bauelement einen ersten elektrischen Kontakt und ein Dielektrikum aufweist, wobei die Schicht oder das Bauteil zusammen mit dem ersten elektrischen Kontakt und ein Dielektrikum nebeneinander angeordnet sind und eine planare Schicht bilden.

14. Optoelektronisches Bauelement nach dem vorhergehenden Anspruch,
wobei das Bauelement eine Fotodiode ist, wobei die Schicht oder das Bauteil sowie der erste elektrische Kontakt (2) auf einer ersten p-dotierten Zone (7) angeordnet sind, wobei die erste p-dotierte Zone (7) an ihren Seitenflächen, wie auch von der Unterseite von einer zweiten p-dotierten Zone (6) umgeben ist, wobei die zweite p-dotierte Zone (6) an ihren Seitenflächen wie auch zur Unterseite hin von einer ersten n-dotierten Zone (5) umgeben ist, wobei die erste n-dotierte Zone (5) auf einer zweiten n-dotierten Zone (4) aufgesetzt ist, wobei die zweite n-dotierte Zone (4) auf einem zweiten elektrischen Kontakt (3) angeordnet ist.

## Claims

1. Optoelectronic device which emits or absorbs electromagnetic radiation of a wavelength from the wavelength range of from 850 nm to 1025 nm,
wherein there is arranged directly on the device in the beam path a layer or a component which comprises a material for filtering radiation, wherein the material is obtainable by curing a composition, wherein the composition comprises:
- silicone, and
- at least one colorant which is dispersed in the silicone,
wherein the composition has a relative transmittance of less than 20% for radiation of the wavelength between 400 nm and 700 nm, and
for radiation of the wavelength between 850 nm and 1025 nm has a relative transmittance of over 50%, wherein the silicone is heat-curable in a range from 60 °C to 180 °C.

2. Optoelectronic device according to claim 1,
wherein the composition has a relative transmittance which increases from less than 20% at 700 nm to greater than 50% at 850 nm for radiation of the wavelength between 700 nm and 850 nm.

3. Optoelectronic device according to one of the preceding claims,
wherein the colorant is homogeneously distributed in the silicone.

4. Optoelectronic device according to one of the preceding claims,
wherein the colorant is present in the composition as particles of smaller than 200 µm.

5. Optoelectronic device according to one of the preceding claims,
wherein the composition comprises at least one colorant selected from: Solvent Yellow 179, Solvent Yellow 93, Solvent Yellow 114, Solvent Orange 60, Solvent Orange 107, Solvent Red 179, Solvent Red 135, Solvent Red 111, Solvent Red 195, Solvent Red 52, Solvent Violet 36, Solvent Violet 13, Solvent Blue 97, Solvent Blue 104, Solvent Green 3, Solvent Green 28.

6. Optoelectronic device according to claim 5,
wherein the composition comprises at least one colorant from each one of the three groups I to III:
I) Solvent Yellow 179, Solvent Yellow 93, Solvent Yellow 114, Solvent Orange 60, Solvent Orange 107, Solvent Red 179, Solvent Red 135, Solvent Red 111, Solvent Red 195, Solvent Red 52,
II) Solvent Violet 36, Solvent Violet 13, Solvent Blue 97, Solvent Blue 104,
III) Solvent Green 3, Solvent Green 28.

7. Optoelectronic device according to one of the preceding claims,
wherein the composition comprises a dialkyl silicone and/or aromatic silicone.

8. Optoelectronic device according to one of the preceding claims,
wherein the composition is free of solvents.

9. Method of producing a composition for a filter material in an optoelectronic device according to claim 1, comprising the method steps of:
A) providing a silicone,
B) heating the silicone,
C) adding a colorant to the silicone from B), such that a dispersion is produced,
D) mixing the dispersion from C), such that a mixture is produced,
E) heating the mixture from D) to a temperature of between 60 °C and 80 °C,
F) dispersing the mixture from E), such that a composition for a filter material is produced,
wherein the composition has a relative transmittance of less than 20% for radiation of the wavelength between 400 nm and 700 nm, and
for radiation of the wavelength between 850 nm and 1025 nm has a relative transmittance of over 50%.

10. Method according to claim 9, comprising the additional method step of:
G) applying the composition from F) to a surface, such that a layer is formed.

11. Method according to claim 10,
wherein the layer has the same absorption characteristic over its entire surface.

12. Device according to claim 1,
wherein the layer or the component is a daylight filter.

13. Optoelectronic device according to claim 1,
wherein the device comprises a first electrical contact and a dielectric, wherein the layer or the component together with the first electrical contact and a dielectric are arranged adjacent one another and form a planar layer.

14. Optoelectronic device according to the preceding claim,
wherein the device is a photodiode, wherein the layer or the component and the first electrical contact (2) are arranged on a first p-doped zone (7), wherein the first p-doped zone (7) is surrounded at its side faces, as well as from the bottom, by a second p-doped zone (6), wherein the second p-doped zone (6) is surrounded at its side faces, as well as towards the bottom, by a first n-doped zone (5), wherein the first n-doped zone (5) is placed on a second n-doped zone (4), wherein the second n-doped zone (4) is arranged on a second electrical contact (3).

## Revendications

1. Composant optoélectronique qui émet ou absorbe un rayonnement électromagnétique d'une longueur d'onde de la plage de longueur d'onde de 850 nm à 1025 nm,
une couche ou un élément étant disposé sur le composant directement dans la trajectoire du faisceau, lequel élément présente une matière destinée à filtrer le rayonnement, la matière étant obtenue par durcissement d'une composition, la composition comprenant :
- du silicone et
- au moins un colorant qui est dispersé dans le silicone,
la composition présentant pour le rayonnement de la longueur d'onde entre 400 nm et 700 nm une transmission relative inférieure à 20%, et
pour le rayonnement de la longueur d'onde entre 850 nm et 1025 nm, présentant une transmission relative supérieure à 50%, le silicone étant thermiquement durcissable dans une plage de 60° C à 180° C.

2. Composant optoélectronique selon la revendication 1, la composition pour le rayonnement de la longueur d'onde entre 700 nm et 850 nm présentant une transmission relative qui augmente, de moins de 20% à 700 nm, à plus 50% à 850 nm.

3. Composant optoélectronique selon l'une quelconque des revendications précédentes,
le colorant étant réparti de manière homogène dans le silicone.

4. Composant optoélectronique selon l'une quelconque des revendications précédentes,
le colorant étant présent dans la composition en tant que particules de moins de 200 µm.

5. Composant optoélectronique selon l'une quelconque des revendications précédentes,
la composition comprenant au moins un colorant sélectionné parmi les groupes : Solvent Yellow 179, Solvent Yellow 93, Solvent Yellow 114, Solvent Orange 60, Solvent Orange 107, Solvent Red 179, Solvent Red 135, Solvent Red 111, Solvent Red 195, Solvent Red 52, Solvent Violet 36, Solvent Violet 13, Solvent Blue 97, Solvent Blue 104, Solvent Green 3, Solvent Green 28.

6. Composant optoélectronique selon la revendication 5,
la composition comprenant au moins un colorant constitué de respectivement un des trois groupes I à III :
I) Solvent Yellow 179, Solvent Yellow 93, Solvent Yellow 114, Solvent Orange 60, Solvent Orange 107, Solvent Red 179, Solvent Red 135, Solvent Red 111, Solvent Red 195, Solvent Red 52,
II) Solvent Violet 36, Solvent Violet 13, Solvent Blue 97, Solvent Blue 104,
III) Solvent Green 3, Solvent Green 28.

7. Composant optoélectronique selon l'une quelconque des revendications précédentes,
la composition comprenant un dialkyl-silicone et/ou un silicone aromatique.

8. Composant optoélectronique selon l'une quelconque des revendications précédentes,
la composition étant exempte de solvants.

9. Procédé de fabrication d'une composition pour une matière filtrante dans un composant optoélectronique selon la revendication 1, comprenant les étapes de procédé :
A) fourniture d'un silicone,
B) échauffement du silicone,
C) mélange du silicone obtenu à B) avec un colorant de manière à obtenir une dispersion,
D) mélange de la dispersion obtenue à C) de manière à obtenir un mélange,
E) échauffement du mélange, obtenu à D), à une température comprise entre 60 °C et 80 °C,
F) dispersion du mélange obtenu à E) de manière à obtenir une composition pour une matière filtrante,
la composition pour le rayonnement de la longueur d'onde entre 400 nm et 700 nm présentant une transmission relative inférieure à 20%, et
pour le rayonnement de la longueur d'onde entre 850 nm et 1025 nm, présentant une transmission relative supérieure à 50%.

10. Procédé selon la revendication 9, comprenant l'étape de procédé supplémentaire :
G) application de la composition obtenue à F) sur une surface, de sorte qu'une couche soit formée.

11. Procédé selon la revendication 10,
la couche présentant sur toute sa surface la même caractéristique d'absorption.

12. Composant selon la revendication 1,
la couche ou le composant étant un filtre jour.

13. Composant optoélectronique selon la revendication 1,
le composant présentant un premier contact électrique et un diélectrique, la couche ou le composant, avec le premier contact électrique et un diélectrique, étant disposés côte à côte et formant une couche planaire.

14. Composant optoélectronique selon la revendication précédente,
le composant étant une photodiode, la couche ou le composant ainsi que le premier contact électrique (2) étant disposés sur une première zone (7) dopée p, la première zone (7) dopée p étant entourée sur ses surfaces latérales, tout comme par-dessous, par une deuxième zone (6) dopée p, la deuxième zone (6) dopée p étant entourée sur ses surfaces latérales, tout comme vers le côté inférieur, par une première couche (5) dopée n, la première couche (5) dopée n étant posée sur une deuxième couche (4) dopée n, la deuxième couche (4) dopée n étant disposée sur un deuxième contact électrique (3).
